# DEMANDE DE BREVET EUROPEEN

(11) **EP 1 274 166 A1**
(43) Date de publication de la demande: **08.01.2003**
(21) Numéro de dépôt: 02077497.2
(22) Date de dépôt: 24.06.2002
(51) Int. Cl.: H03G 7/00, H03F 3/45

(54) **Reduction de sensibilité d'un amplificateur à une tension de décalage**

(30) Priorité: 04.07.2001 FR 0108894
(71) Demandeur: Koninklijke Philips Electronics N.V., 5621 BA Eindhoven (NL)
(72) Inventeur: Desbonnets, Eric, Société Civile S.P.I.D., 75008 Paris (FR); Lebailly, Guillaume, Société Civile S.P.I.D., 75008 Paris (FR)
(74) Mandataire: Chaffraix, Jean

(57) **Abrégé**

L'invention concerne un procédé pour amplifier un signal d'entrée [VIN,IIN] comportant une composante continue et une composante alternative, incluant les étapes suivantes :
- comparaison [GEN] du signal d'entrée [VIN,IIN] avec une valeur de référence,
- génération d'un signal intermédiaire [IINT] par soustraction [SUB] au signal d'entrée [VIN,IIN] d'un signal dit de correction [ICOR] résultant de ladite comparaison [GEN],
- redressement [RED] du signal intermédiaire [IINT],
- évaluation [MEA] d'une valeur moyenne [IRECT] du signal intermédiaire redressé [IRED],
- multiplication [GAIN] du signal d'entrée [VIN,IIN] par ladite valeur moyenne [IRECT].
L'invention permet une réduction de la sensibilité de l'amplificateur à la composante continue du signal d'entrée.

Application : Amplification de signaux analogiques.

## Description

L'invention concerne un procédé pour amplifier un signal d'entrée comportant une composante continue et une composante alternative.

L'invention s'applique plus particulièrement aux circuits intégrés pour le traitement de signaux audio. Elle concerne donc particulièrement les circuits d'émission réception pour les téléphones sans fils.

Ces circuits utilisent généralement un dispositif pour optimiser la bande passante et améliorer le rapport signal sur bruit du signal démodulé. Ce dispositif est constitué de deux blocs : un compresseur pour la partie transmission et un amplificateur (expander en anglais) pour la partie réception. Ces deux blocs sont très sensibles aux tensions de décalage. Ainsi, ces deux blocs sont en général couplés à une capacité qui fait office de filtre passe-haut afin que l'éventuel décalage introduit par des blocs précédents soit annulé. Cette mise en oeuvre a l'avantage d'annuler le décalage mais coûte une capacité externe et deux plots de connexion.

Un but de l'invention est de permettre de réduire la sensibilité de l'amplificateur au décalage en tension sans utiliser un tel couplage à une capacité.

En effet, un procédé pour amplifier un signal d'entrée comportant une composante continue et une composante alternative est remarquable selon l'invention en ce qu'il inclut les étapes suivantes :
- comparaison du signal d'entrée avec une valeur de référence,
- génération d'un signal intermédiaire par soustraction au signal d'entrée d'un signal dit de correction résultant de ladite comparaison,
- redressement du signal intermédiaire,
- évaluation d'une valeur moyenne du signal intermédiaire redressé,
- multiplication du signal d'entrée par ladite valeur moyenne.
Le procédé selon l'invention propose en effet un compromis qui prend en compte l'évolution dans le temps du signal d'entrée pour supprimer une tension de décalage. La valeur du signal d'entrée est comparée à chaque instant à une valeur de référence et cette comparaison engendre la génération d'un courant de correction. L'invention permet d'éviter d'utiliser une capacité externe et par conséquent coûteuse à mettre en oeuvre. L'invention permet également d'éviter la multiplication des plots de connexion qui sont des sources d'erreur lors de la fabrication. De plus, l'invention présente un avantage déterminant et supplémentaire de réduction de souffle lors de l'amplification selon le procédé de l'invention. Cet avantage est particulièrement intéressant pour les applications de réception audio. Dans une de ses applications, l'invention concerne également un dispositif incluant des modules pour réaliser les fonctions selon l'invention. Plus généralement, la présente invention peut être avantageusement mise en oeuvre dans un appareil, par exemple, un téléphone sans fil dont la chaîne de réception comprend des éléments susceptibles d'introduire un décalage au sein du traitement du signal reçu.

L'invention sera mieux comprise à la lumière de la description suivante de quelques modes de réalisation, faite à titre d'exemple et en regard des dessins annexés, dans lesquels :
- la figure 1 est un schéma bloc décrivant le fonctionnement classique d'un amplificateur pour la réception,
- la figure 2 illustre le fonctionnement d'un amplificateur classique sans correction pour des signaux d'amplitude importante,
- la figure 3 illustre le fonctionnement d'un amplificateur classique sans correction pour des signaux d'amplitude faible,
- la figure 4 est un schéma bloc d'un amplificateur avec correction selon l'invention,
- la figure 5 illustre la génération d'un signal de correction selon l'invention et le signal intermédiaire obtenu selon l'invention ainsi que la moyenne de ce signal intermédiaire redressé,
- la figure 6 est un diagramme de gain pour illustrer l'action de la correction sur l'amplification.

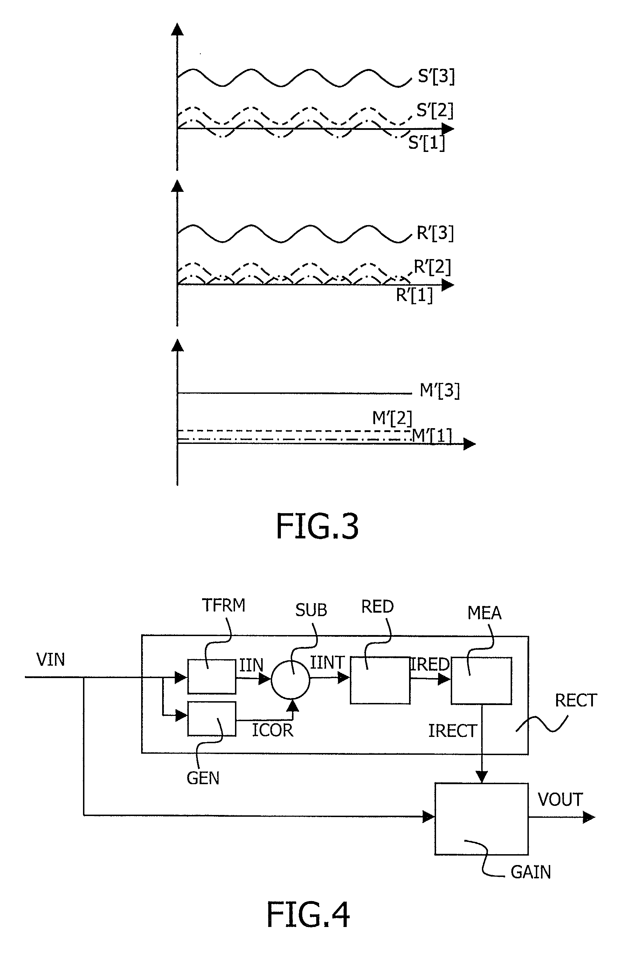

La description qui va suivre est présentée pour permettre à un homme du métier de réaliser et de faire usage de l'invention. Cette description est fournie dans le contexte de la demande de brevet et de ses exigences. Des alternatives diverses au mode de réalisation préféré seront évidentes à l'homme du métier et les principes génériques de l'invention exposés ici peuvent être appliqués à d'autres mises en oeuvre.
Ainsi, la présente invention n'est pas censée être limitée au mode de réalisation décrit mais plutôt avoir la portée la plus large en accord avec les principes et les caractéristiques décrites ci-après.

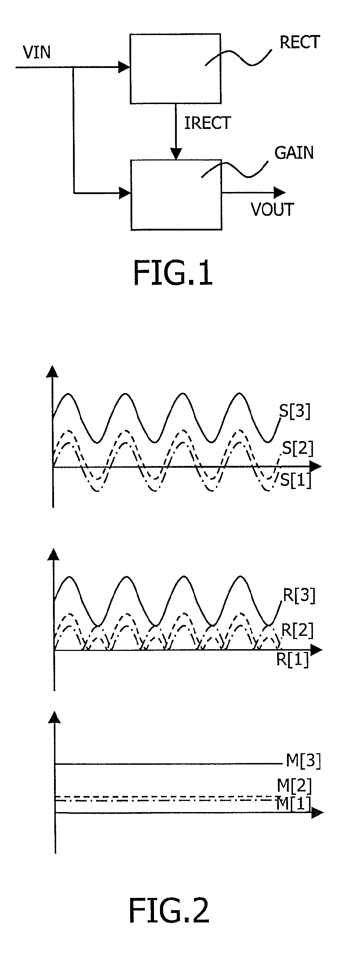

La figure 1 est un schéma bloc illustrant le fonctionnement classique d'un amplificateur tel que généralement implémenté pour le traitement analogique du signal audio. L'amplificateur inclut un bloc de rectification RECT qui redresse le signal d'entrée et filtre le signal redressé afin d'obtenir la valeur moyenne IRECT du signal redressé. IRECT est le signal de sortie du bloc RECT. Un bloc de gain GAIN multiplie ensuite le signal d'entrée par cette valeur moyenne IRECT. Dans le mode de réalisation préféré, le signal d'entrée est une tension. Une tension de décalage est définie par une tension continue dans le temps ajoutée au signal dit utile qui est d'une fréquence donnée en fonction de son utilité. La tension de décalage est une tension parasite généralement induite par la présence d'autres fonctionnalités le long de la chaîne de traitement analogique des données audio.
S'il n'y a pas de tension de décalage dans le signal d'entrée VIN, celui-ci s'écrit en fonction de la valeur du signal utile VSIG VIN(t)= |VSIG| .sinωSIG.t. Cette tension est fournie à l'entrée des deux blocs RECT et GAIN. Le bloc RECT génère alors un courant IRECT = α. |VSIG| = α. |VIN| proportionnel à la valeur moyenne du signal d'entrée. Cela est spécialement illustré par les courbes S[1], R[1] et M[1] sur la figure 2 et S'[1], R'[1] et M'[1] sur la figure 3. M[1] et M'[1] sont les valeurs moyennes IRECT envoyées au bloc GAIN. Le bloc GAIN multiplie alors la tension d'entrée par IRECT. Par conséquent, le signal de sortie VOUT=|VOUT|.sinωSIG.t est tel que |VOUT| = α.|VIN|². Cette dernière expression est l'amplification idéalement réalisée par un amplificateur au sein par exemple d'une chaîne de réception d'un signal audio.
Si le signal d'entrée contient une tension de décalage VOFF, la sortie du bloc de rectification RECT est fausse car elle est telle que IRECT = α.|VSIG|+β, où β = α. |VOFF|. Pour les fortes valeurs de |VSIG| l'impact est faible sur le résultat final de l'amplification. En revanche cela devient critique pour les faibles amplitudes d'entrée et en particulier pour le bruit d'entrée. La fonction de l'amplificateur consistant notamment à réduire le bruit d'entrée sera donc fortement dégradée.
En effet pour un signal d'entrée VIN tel que :
VIN = VSIG+VOFF où VSIG est d'une amplitude importante par rapport à VOFF, IRECT = α. |VSIG|+β ≈ α. |VSIG| car β = α. |VOFF| est négligeable. La fonction de l'amplificateur est alors correcte et |VOUT| est proportionnel à |VSIG|² qui est d'ailleurs proche de |VIN|². Cela est par exemple illustré dans le cas d'une tension de décalage faible par rapport à l'amplitude du signal par les courbes S[2], R[2] et M[2] sur la figure 2.
Pour un signal d'entrée tel que VIN = VNOISE+VOFF,
IRECT = α. |VNOISE|+β ≈ β car α. |VNOISE| est négligeable. Cela est illustré par les courbes S[3], R[3] et M[3] sur la figure 2 (pour une tension de décalage importante par rapport à l'amplitude du signal utile) et S'[2], R'[2] et M'[2] ainsi que S'[3], R'[3] et M'[3] sur la figure 3 pour des signaux d'entrée de faibles amplitudes. Dans ce cas le bruit n'est pas réduit et la sortie de l'amplificateur est VOUT = β|VIN| = α.|VOFF| |VIN|≈ α.|VOFF|². La sortie n'est donc pas proportionnelle à |VSIG|² et n'est pas correcte. L'amplificateur ne rejette donc pas les signaux de faibles amplitudes.
Une solution classique à ce problème consiste à coupler l'amplificateur à un filtre passe-haut (un condensateur par exemple) de manière à supprimer les composantes continues du signal d'entrée. Cela est coûteux en espace d'intégration car cela nécessite la présence d'une capacité externe couplée à l'amplificateur et de deux plots de connexion supplémentaires.
En se référant à la figure 4, l'invention propose une structure particulière du bloc de rectification RECT. La chaîne de fonctions classiquement implémentée au sein du bloc RECT dans les amplificateurs consiste à redresser le signal d'entrée dans une étape de redressement RED puis à calculer la moyenne du signal redressé IRECT dans une étape MEA. Dans le mode de réalisation préféré, le signal d'entrée est une tension VIN, cette tension VIN est transformée en un courant IIN, dit courant d'entrée, au sein d'une étape TFRM. Cette dernière étape est réalisée par des moyens classiques de transformation tension-courant, par exemple à l'aide d'une résistance. Ce courant est ensuite redressé et moyenné selon la chaîne de fonctions classiquement implémentée. L'invention propose d'ajouter une boucle de contre-réaction à l'entrée du bloc de rectification RECT. La mise en oeuvre de cette boucle est avantageusement réalisée à l'aide d'un bloc de génération de courant GEN qui reçoit en entrée le signal d'entrée, ici, une tension VIN, et qui génère un courant dit de correction ICOR. Ce courant ICOR est ensuite soustrait dans une étape SUB au courant d'entrée IIN. Un courant intermédiaire IINT est obtenu, ce courant est alors redressé en un courant IRED et moyenné en un courant IRECT conformément à la chaîne de fonctions explicitée auparavant.
Selon l'invention, le courant de correction ICOR est généré par comparaison du signal d'entrée VIN ou encore IIN avec une valeur de référence.

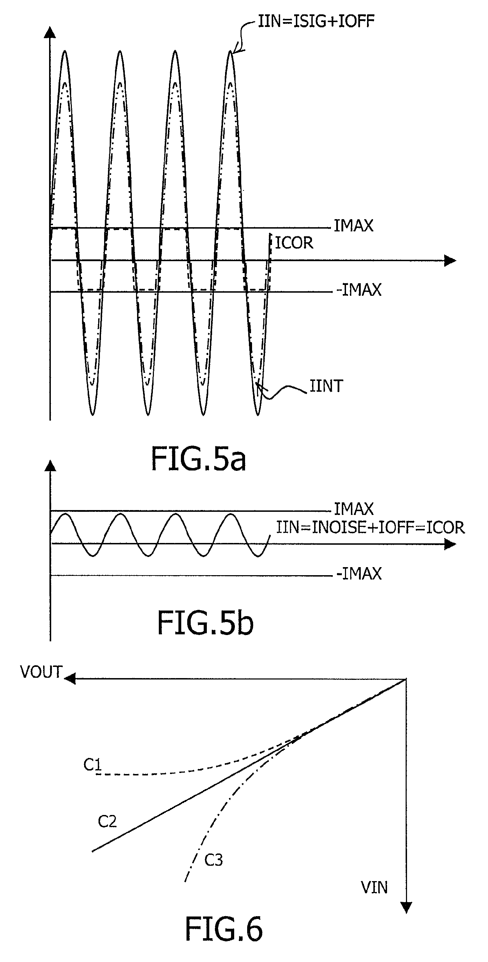

La figure 5 illustre la génération du courant de correction dans trois cas. Les figures 5a, respectivement 5b représentent la génération des courants de correction pour un signal d'entrée IIN d'amplitude importante par rapport au courant de décalage IOFF (correspondant à le tension de décalage VOFF) et respectivement pour un signal d'amplitude faible (pour lequel IINT est égale à zéro). Selon l'invention, le courant IIN est comparé à une valeur de référence IMAX. Dans le mode de réalisation préféré de l'invention et selon la figure 5, le courant d'entrée IIN est comparé à chaque instant à la valeur de référence IMAX. Pour les valeurs de IIN inférieures à IMAX, ICOR est égale à IIN et pour les valeurs supérieures à IMAX, ICOR est égale à IMAX. Le courant de correction alternatif ainsi obtenu est ensuite soustrait au courant d'entrée IIN pour obtenir un signal intermédiaire. IMAX est choisie de manière à compenser la plus grande tension de décalage possible (ou la plus grande intensité de décalage possible dans le cas où le procédé utilise des intensités). Cependant, IMAX ne doit pas être trop importante car dans ce cas des amplitudes importantes de signal peuvent être supprimées. IMAX est donc un compromis entre ces deux grandeurs. Dans les applications visées (chaîne de réception et de traitement analogique de signaux audio), une intensité IMAX fixée à l'intensité de décalage maximum permet de ne pas occulter les amplitudes importantes de manière significative. En effet, l'inconvénient d'une valeur élevée est que les signaux d'amplitudes inférieures à cette valeur sont supprimés. Un avantage supplémentaire de l'invention consiste à permettre une réduction du souffle (squelch en anglais) à l'amplification. Cela permet d'améliorer la qualité du son du récepteur, par exemple lorsqu'un écouteur est mis à la sortie de l'amplificateur. En effet, l'invention permet d'obtenir une amplification de bonne qualité peu sensible à une tension de décalage en même temps qu'une bonne réduction du souffle. Le signal finalement obtenu est ainsi épuré et par conséquent de très bonne qualité. Un tel avantage peut s'avérer déterminant. La fonction de réduction du souffle est en effet assurée par une fixation de IMAX à une valeur correspondant à une limite inférieure pour le signal utile. Le souffle est rejeté de l'amplification tant qu'il est en dessous de la valeur de IMAX. La valeur IMAX peut être avantageusement fixée matériellement sur le circuit intégré. Les figures 5a et 5b représentent aussi le signal intermédiaire IINT obtenu par soustraction du courant de correction ICOR au courant d'entrée IIN et la moyenne du signal intermédiaire redressé IRECT. L'invention permet donc d'obtenir une valeur de IRECT proportionnelle à |VSIG|. En particulier, l'invention permet de supprimer la contribution des signaux de faible amplitude. L'invention n'affecte que très peu la proportionnalité à |VSIG| pour les signaux d'amplitude importante.
La figure 6 illustre ce comportement en présentant un diagramme de gain reportant l'amplification réalisée par un amplificateur classique auquel se présente un signal avec tension de décalage et sans correction (C1), auquel se présente un signal sans tension de décalage et sans correction (C2) et avec correction selon l'invention (C3).
Il existe de nombreuses façons de mettre en oeuvre les fonctions présentées dans les étapes des procédés selon l'invention par des moyens logiciels et/ou matériels accessibles à l'homme du métier. C'est pourquoi les figures sont schématiques. Ainsi, bien que les figures montrent différentes fonctions réalisées par différents blocs, cela n'exclut pas qu'un seul moyen logiciel et/ou matériel permette de réaliser plusieurs fonctions. Cela n'exclut pas non plus qu'une combinaison de moyens logiciels et/ou matériels permette de réaliser une fonction.
Bien que cette invention ait été décrite en accord avec les modes de réalisation présentés, un homme du métier reconnaîtra immédiatement qu'il existe des variantes aux modes de réalisation présentés et que ces variantes restent dans l'esprit et sous la portée de la présente invention.
Ainsi, de nombreuses modifications peuvent être réalisées par un homme du métier sans pour autant s'exclure de l'esprit et de la portée définies par les revendications suivantes.

## Revendications

1. Procédé pour amplifier un signal d'entrée comportant une composante continue et une composante alternative, incluant les étapes suivantes :
- comparaison du signal d'entrée avec une valeur de référence,
- génération d'un signal intermédiaire par soustraction au signal d'entrée d'un signal dit de correction résultant de ladite comparaison,
- redressement du signal intermédiaire,
- évaluation d'une valeur moyenne du signal intermédiaire redressé,
- multiplication du signal d'entrée par ladite valeur moyenne.

2. Procédé selon la revendication 1, **caractérisé en ce que** la valeur dudit signal de correction est égale à la valeur de référence pour les valeurs du signal d'entrée supérieures à la valeur de référence et est égale à la valeur du signal d'entrée lorsque le signal d'entrée est inférieur à la valeur de référence.

3. Procédé selon l'une des revendications 1 et 2, **caractérisé en ce que** le choix de la valeur de référence permet de supprimer des signaux parasites alternatifs.

4. Dispositif pour amplifier un signal d'entrée comportant une composante continue et une composante alternative, incluant des modules pour :
- comparer le signal d'entrée avec une valeur de référence,
- générer un signal intermédiaire par soustraction au signal d'entrée d'un signal dit de correction résultant de ladite comparaison,
- redresser le signal intermédiaire,
- évaluer une valeur moyenne du signal intermédiaire redressé,
- multiplier le signal d'entrée par ladite valeur moyenne.

5. Dispositif selon la revendication 4, **caractérisé en ce que** la valeur dudit signal de correction est la valeur de référence pour les valeurs du signal d'entrée supérieures à la valeur de référence et est égale à la valeur du signal d'entrée lorsque le signal d'entrée est inférieur à la valeur de référence.

6. Dispositif selon l'une des revendications 4 et 5, **caractérisé en ce que** le choix de la valeur de référence permet de supprimer des signaux parasites alternatifs.
